# EUROPEAN PATENT SPECIFICATION

(11) **EP 2 495 572 B1**
(45) Date of publication and mention of the grant of the patent: **05.06.2013**
(21) Application number: 11797806.4
(22) Date of filing: 17.06.2011
(51) Int. Cl.: G01P 15/12, B81B 3/00, G01P 15/18, H01L 29/84

(54) **ACCELERATION SENSOR**
BESCHLEUNIGUNGSMESSER
CAPTEUR D'ACCÉLÉRATION

(30) Priority: 25.06.2010 JP 2010144644
(43) Date of publication of application: 05.09.2012
(73) Proprietor: Panasonic Corporation, Kadoma-shi Osaka 571-8501 (JP)
(72) Inventor: IMANAKA, Takashi, Osaka-shi, Osaka 540-6207 (JP)
(74) Representative: Vigand, Philippe
(86) International application number: PCT/JP2011/003466
(87) International publication number: WO 2011/161917

(56) References cited:
- EP-A1- 0 899 551
- WO-A1-2008/038537
- GB-A- 1 151 435
- JP-A- 9 018 070
- JP-A- 9 061 453
- JP-A- 2009 243 915
- US-A- 4 116 075
- US-A1- 2008 216 573

## Description

### TECHNICAL FIELD

The technical field relates to an acceleration sensor detecting acceleration or angular velocity used for a mobile terminal or a vehicle.

### BACKGROUND ART

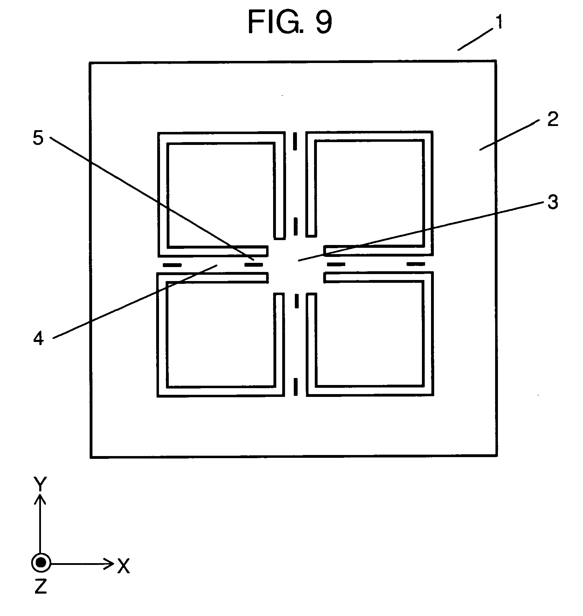

Referring to Fig. 9, conventional acceleration sensor 1 includes frame 2, weight portion 3, arm portion 4 for connecting frame 2 and weight portion 3, and sensing portion 5 for detecting a bend of arm portion 4.

It is to be noted that as related art document information concerning this application, for example, Unexamined Japanese Patent Publication No. 2007-85800 (Patent Document 1) is known.

For example, in acceleration sensor 1, piezoresistance is used as sensing portion 5. Because the piezoresistance has a large resistance temperature coefficient to express a rate of change of the electrical resistance by the temperature change, it is difficult to adopt it in a terminal used in a wide temperature range. On the other hand, a rate of change of the electrical resistance for the temperature change is small when a strain resistor film consists of the metal oxide as sensing portion 5. However, the strain resistor film consisting of the metal oxide has low sensitivity because a gauge factor to express a change of resistance for distortion is small.

### CITATION LIST

### [Patent Documents]

[Patent Document 1] Japanese Patent Unexamined Publication No. 2007-85800

### SUMMARY OF INVENTION

An acceleration sensor of the present invention includes a frame, a weight portion, an arm portion for connecting the frame and the weight portion, and a sensing portion for detecting a bend of the arm portion. The sensing portion includes a first electrode portion and a second electrode portion provided on the weight portion, and a strain resistor portion. A first end of the strain resistor portion is connected to the first electrode portion, and a second end of the strain resistor portion is connected to the second electrode portion. The strain resistor portion is formed of a strain resistor film consisting of the metal oxide. The strain resistor portion is formed in meander shape in the part which is nearer to the weight portion than the frame in the arm portion.

Alternatively, an acceleration sensor includes a frame, a weight portion, an arm portion for connecting the frame and the weight portion, and a sensing portion for detecting a bend of the arm portion. The sensing portion includes a first electrode portion and a second electrode portion provided on the frame, and a strain resistor portion. A first end of the strain resistor portion is connected to the first electrode portion, and a second end of the strain resistor portion is connected to the second electrode portion. The strain resistor portion is formed of a strain resistor film consisting of the metal oxide. The strain resistor portion is formed in meander shape in the frame side of the arm portion.

With this structure, the acceleration sensor has a small resistance temperature coefficient and a large gauge factor.

### BRIEF DESCRIPTION OF DRAWINGS

Fig. 1 is a top view of an acceleration sensor according to Exemplary Embodiment.
Fig. 2 is a partially enlarged view of the acceleration sensor according to Exemplary Embodiment.
Fig. 3 is a partially enlarged view of another acceleration sensor according to Exemplary Embodiment.
Fig. 4 is a partially enlarged view of another acceleration sensor according to Exemplary Embodiment.
Fig. 5 is a partially enlarged view of another acceleration sensor according to Exemplary Embodiment.
Fig. 6 is a top view of the acceleration sensor according to Exemplary Embodiment.
Fig. 7A shows an exemplary circuit of the acceleration sensor according to Exemplary Embodiment.
Fig. 7B shows an exemplary circuit of the acceleration sensor according to Exemplary Embodiment.
Fig. 7C shows an exemplary circuit of the acceleration sensor according to Exemplary Embodiment.
Fig. 8 is a top view of another acceleration sensor according to Exemplary Embodiment.
Fig. 9 is a top view of a conventional acceleration sensor.

### DESCRIPTION OF EMBODIMENTS

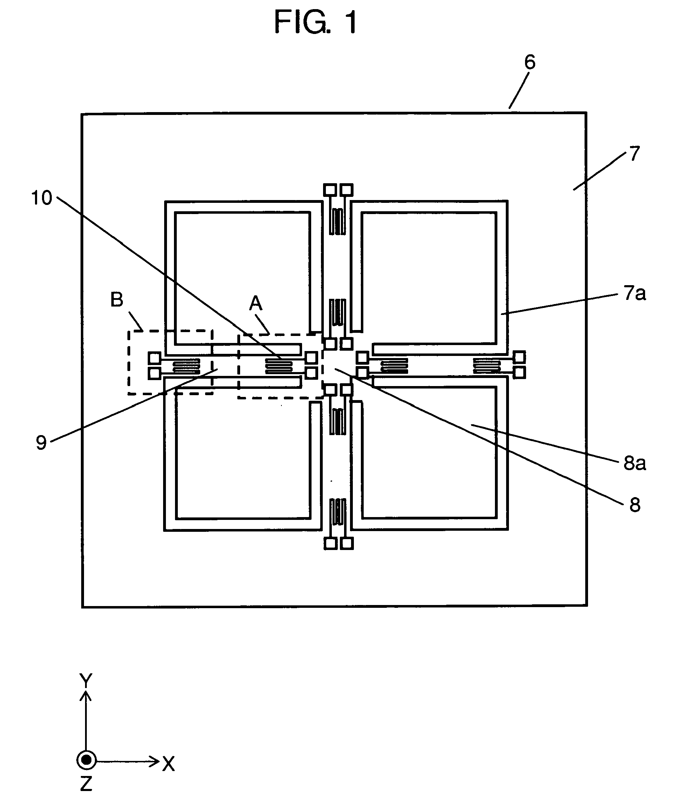

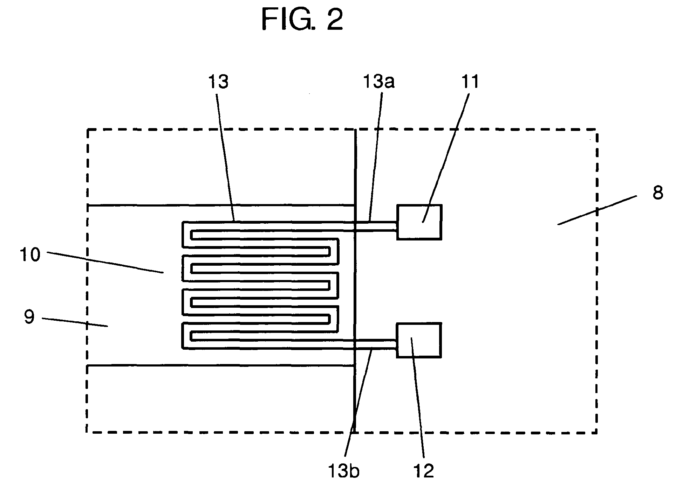

An exemplary embodiment of the present invention will be described as follows with reference to the drawings. Fig. 1 is a top view of an acceleration sensor according to Exemplary Embodiment. Fig. 2 is an enlarged view of the central part of part A which is surrounded by a dotted line in Fig. 1.

Referring to Fig. 1, acceleration sensor 6 includes frame 7, weight portion 8, arm portion 9 for connecting frame 7 and weight portion 8, and sensing portion 10 for detecting a bend of arm portion 9.

Sensing portion 10 includes first electrode portion 11 and second electrode portion 12 provided on weight portion 8, and strain resistor portion 13. First end 13a of strain resistor portion 13 is connected to first electrode portion 11, and second end 13b of strain resistor portion 13 is connected to second electrode portion 12. Strain resistor portion 13 is formed of a strain resistor film comprising a metal oxide. Strain resistor portion 13 is formed in meander shape in the weight portion 8 side on arm portion 9.

With this structure, the acceleration sensor has a small resistance temperature coefficient and a large gauge factor.

Seeing from the top surface, frame 7 is formed in quadrangle. Frame 7 has hollow 7a in the center.

Weight portion 8 is provided in the center of hollow 7a. Arm portion 9 is formed to connect frame 7 and weight portion 8. Arm portion 9 is provided in four places between frame 7 and weight portion 8. Weight portion 8 is supported by arm portion 9. Hollow 7a is divided in the shape of a substantially cruciform in four divisions by weight portion 8 and arm portion 9 placed in the four places.

Subsidiary weight 8a is formed from each of the four corners of weight portion 8 to each division of hollow 7a.

Frame 7, arm portion 9, weight portion 8, and subsidiary weight 8a may include piezoelectric materials such as crystal, LiTaO₃, and LiNbO₃ and may comprise non piezoelectric materials such as silicon, molten quartz, and alumina. When frame 7, arm portion 9, weight portion 8, and subsidiary weight 8a comprise silicon, it is preferable because a small acceleration sensor can be made by nanofabrication technology.

Preferably, arm portion 9 is formed more thinly than frame 7, weight portion 8, and subsidiary weight 8a. When arm portion 9 is formed thinly, arm portion 9 becomes easy to bend. Therefore, weight portion 8 and subsidiary weight 8a can be displaced more largely by acceleration given from the outside. Preferably, the thickness of frame 7 is same as that of weight portion 8 and that of subsidiary weight 8a. Thus, a manufacturing process can be simplified.

First electrode portion 11 and second electrode portion 12 are electrodes to measure a resistance level of strain resistor portion 13. First electrode portion 11 and second electrode portion 12 comprise the same material as that of strain resistor portion 13. An insulation film (not shown) comprising SiN or SiO₂ is formed on arm portion 9 and strain resistor portion 13. Electrode pads (not shown) are provided in the end of frame 7. Wires are formed on the insulation film. First electrode portion 11 and second electrode portion 12 are connected to the electrode pads (not shown) and a detecting circuit (not shown) electrically by the wires. First electrode portion 11 and second electrode portion 12 are on weight portion 8. Thus noise mixed with signals picked up by first electrode portion 11 and second electrode portion 12 can be suppressed. When first electrode portion 11 and second electrode portion 12 are provided on arm portion 9, noise is mixed with signals picked up by first electrode portion 11 and second electrode portion 12 due to a bend which occurs in arm portion 9.

For example, strain resistor portion 13 is formed of a strain resistor film comprising the metal oxide such as zinc oxide, chromium oxide, and nickel oxide. Strain resistor portion 13 is formed in meander shape in the weight portion 8 side in arm portion 9. When acceleration is applied to acceleration sensor 6, weight portion 8 and subsidiary weight 8a are displaced so that arm portion 9 bends. In arm portion 9, the quantity of bend of the central part is larger than quantity of bend of the edge. In other words, in arm portion 9, the quantity of bend becomes progressively greater near a border part between arm portion 9 and weight portion 8 or a border part between arm portion 9 and frame 7.

Therefore, when strain resistor portion 13 is formed in the weight portion 8 side in arm portion 9, the gauge factor can be large.

The quantity of bend is detected by the change of the resistance level of strain resistor portion 13. Therefore, the absolute value of the resistance level change for the same bend quantity becomes progressively greater as the length of strain resistor portion 13 per length of arm portion 9 becomes longer. Therefore, when strain resistor portion 13 is formed in meander shape, the length of strain resistor portion 13 per length of arm portion 9 can be longer and the gauge factor can be larger.

When strain resistor portion 13 is formed as piezoresistance, the boron of the P type is diffused in arm portion 9 comprising the silicon of the N type, and the diffusion layers are formed. Therefore, a leak current occurs between the diffusion layers facing to each other when the meander shaped diffusion layers are formed in narrow arm portion 9. Between the diffusion layers facing to each other, only p-n junction (i.e., only the silicon) prevents the diffusion of the electric charge. Because the diffusion layers are spread by an anneal step, the withstanding voltage comes down between the diffusion layers facing to each other, and a leak current occurs. In this embodiment, strain resistor portion 13 is formed of the strain resistor film comprising the metal oxide. Between the strain resistor films facing each other, an insulator comprising SiN or SiO₂ exists. Therefore, the withstanding voltage is high and the occurrence of the leak current is prevented. Preferably, an insulator such as SiO₂ is formed to cover strain resistor portion 13. Thus, the occurrence of the leak current is more prevented and wires may be formed on the insulator.

Referring to Fig. 2, first electrode portion 11 and second electrode portion 12 are provided on weight portion 8. Even if first electrode portion 11 and second electrode portion 12 are provided on frame 7, and strain resistor portion 13 is provided in meander shape in the frame 7 side of arm portion 9 as shown in part B of Fig. 1, a similar effect is provided. More specifically, in arm portion 9, the part with much quantity of bend is the part which is near to the border part between arm portion 9 and frame 7. Because strain resistor portion 13 is formed in meander shape on the part which is near to the border part between arm portion 9 and frame 7, the acceleration sensor can have a high gauge factor and a law resistance temperature coefficient.

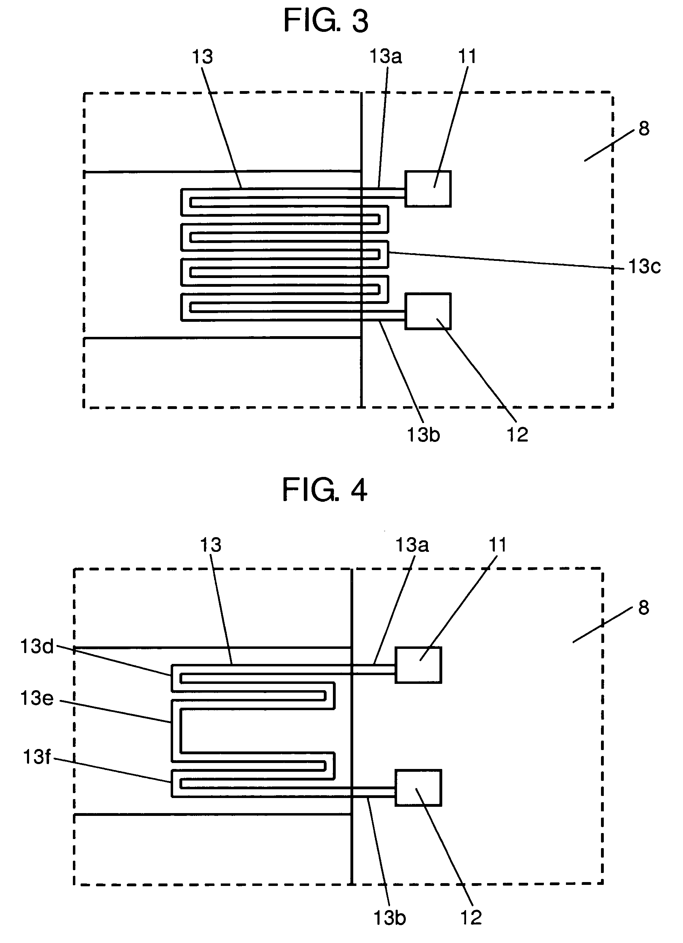

Fig. 3 is a partially enlarged view of another acceleration sensor according to Exemplary Embodiment. Portion 13c, which is a part of a meander-shaped part of strain resistor portion 13, is formed on weight portion 8. When strain resistor portion 13 is formed like this , strain resistor portion 13 is formed in the border part, which has the largest quantity of bend, between weight portion 8 and arm portion 9. Thus, a high gauge factor is provided. In addition, even if strain resistor portion 13 comes close to the center of arm portion 9 by production unevenness, strain resistor portion 13 is formed surely near the border, which has a largest quantity of bend, between weight portion 8 and arm portion 9. Similarly, when first electrode portion 11 and second electrode portion 12 are provided on frame 7, strain resistor portion 13 can be formed in the border between frame 7 and arm portion 9 if a part of meander-shaped portion 13c of strain resistor portion 13 is formed on frame 7.

Fig. 4 is a partially enlarged view of another acceleration sensor according to Exemplary Embodiment. A meander-shaped part of strain resistor portion 13 includes first meander portion 13d, second meander portion 13f, and connection portion 13e. First meander portion 13d and second meander portion 13f are bent alternately. Connection portion 13e connects first meander portion 13d and second meander portion 13f. Then, the width between first meander portion 13d and second meander portion 13f, namely, width of connection portion 13e is formed wider than the width between strain resistor portions that are next to each other in first meander portion 13d and second meander portion 13f. An insulation film comprising SiN or SiO₂ is formed on arm portion 9 and strain resistor portion 13. First electrode portion 11 and second electrode portion 12 are electrically connected with a pad of electrode provided in the edge of frame 7 by wires which are formed on the insulation film. By forming the wires such that the wires goes through over connection portion 13e, the area in which wires and strain resistor portion 13 face each other becomes small. Therefore, insulation characteristic between the wires and strain resistor portion 13 are ensured.

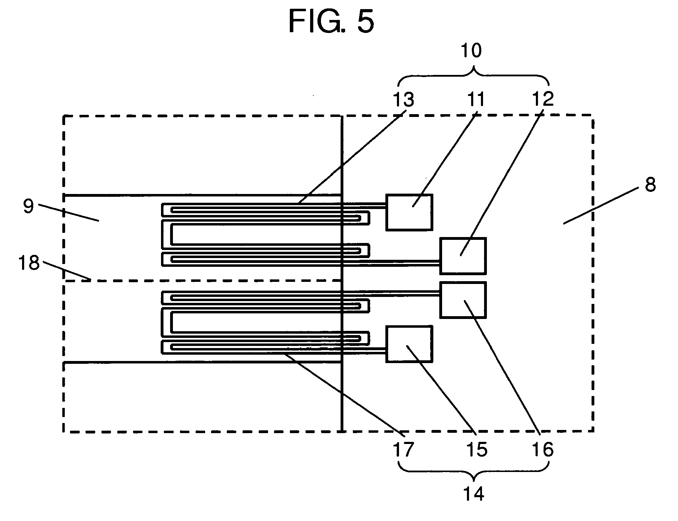

Fig. 5 is a partially enlarged view of another acceleration sensor according to Exemplary Embodiment. Sensing portion 10 includes first electrode portion 11, second electrode portion 12, and strain resistor portion 13. Sensing portion 14 includes first electrode portion 15, second electrode portion 16, and strain resistor portion 17. Sensing portion 10 and sensing portion 14 are formed line symmetrically to center line 18 of arm portion 9. By providing sensing portion 10 and sensing portion 14 as described above, the acceleration sensor can detect two axes of the angular velocity, for example the X-axis and the Z-axis.

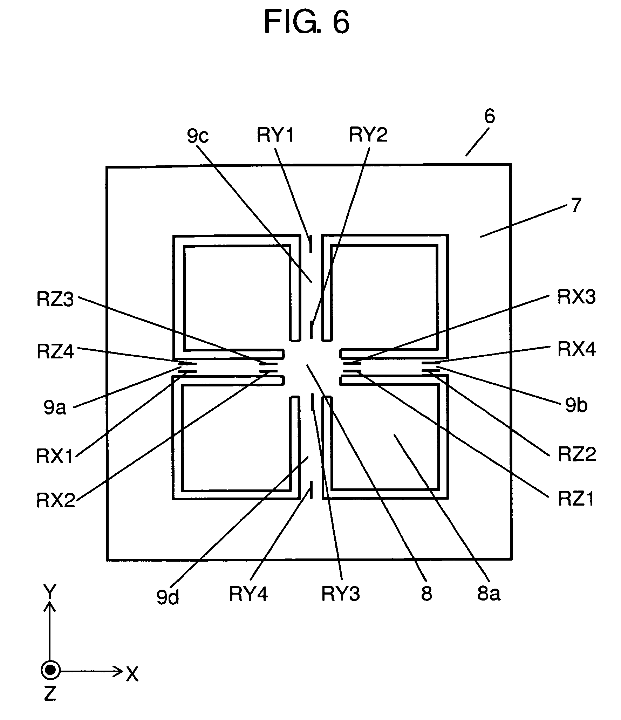

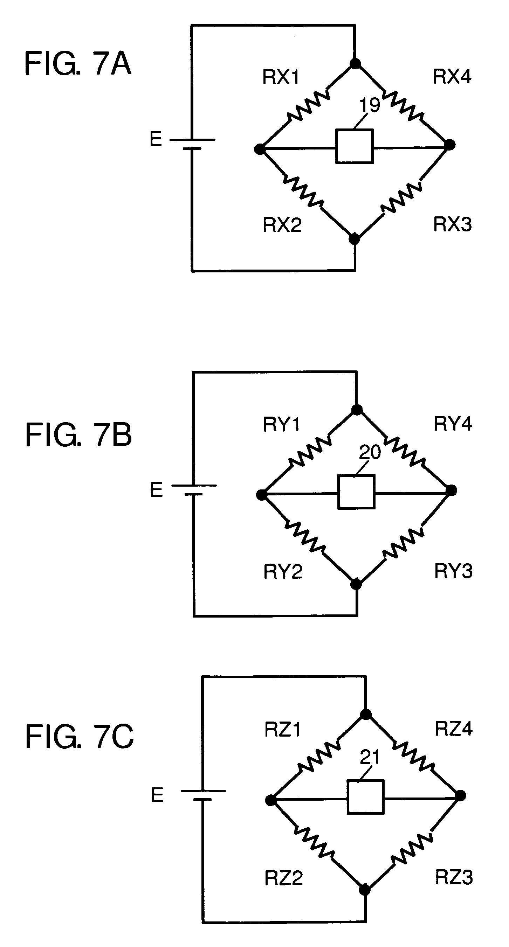

Fig. 6 shows an exemplary layout of sensing portion 10 in acceleration sensor 6 according to Exemplary Embodiment. Fig. 7 shows an exemplary circuit to detect acceleration by the acceleration sensor according to Exemplary Embodiment. Sensing Portions RX1 to RX4, RY1 to RY4 and RZ1 to RZ4 are simplistically shown. All these include first electrode portion, second electrode portion, and strain resistor portion formed in meander shape that are provided on weight portion8 or frame 7 as shown in Figs. 1 to 4.

As shown in Fig 6, arm portion 9a is provided in the negative side of X-axis with respect to weight portion 8. Sensing portions RX1 and RZ4 are provided on the edge of the frame 7 side of arm portion 9a. Sensing portions RX2 and RZ3 are provided on the edge of the weight portion 8 side of arm portion 9a. Arm portion 9b is provided in the positive side of X-axis with respect to weight portion 8. Sensing portions RX4 and RZ2 are provided on the edge of the frame 7 side of arm portion 9b. Sensing portions RX3 and RZ1 are provided on the edge of the weight portion 8 side of arm portion 9b. Arm portion 9c is provided in the positive side of Y-axis with respect to weight portion 8. Sensing portion RY1 is provided on the edge of the frame 7 side of arm portion 9c. Sensing portion RY2 is provided on the edge of the weight portion 8 side of arm portion 9c. Arm portion 9d is provided in the negative side of Y-axis with respect to weight portion 8. Sensing portion RY4 is provided on the edge of the frame 7 side of arm portion 9d. Sensing portion RY3 is provided on the edge of the weight portion 8 side of arm portion 9d.

Fig. 7A shows an exemplary circuit when the acceleration in the X-axis direction is detected. Fig. 7B shows an exemplary circuit when the acceleration in the Y-axis direction is detected. Fig. 7C shows an exemplary circuit when the acceleration in the Z-axis direction is detected. Sensing portions RX1 to RX4 are bridge-connected as shown in Fig. 7A. Voltage E is applied between facing twin connection points, and the acceleration in the X-axis direction can be detected by the detected voltage of voltage detecting portion 19 provided between remaining twin connection points. Sensing portions RY1 to RY4 are bridge-connected as shown Fig. 7B. Voltage E is applied between facing twin connection points, and the acceleration in the Y-axis direction can be detected by the detected voltage of voltage detecting portion 20 provided between remaining twin connection points. Sensing portions RZ1 to RZ4 are bridge-connected as shown Fig. 7C. Voltage E is applied between facing twin connection points, and the acceleration in the Z-axis direction can be detected by the detected voltage of voltage detecting portion 21 provided between remaining twin connection points. Explanation is spared about the movement of weight portion 8 when the acceleration of each of the X-axis, the Y-axis, and Z-axis is applied and the change of the resistance level of each strain resistor portion in this regard. It is disclosed in detail, for example, in Unexamined Japanese Patent Publication No. 2008-224294.

Because acceleration sensor 6 is configured as described above, weight portion 8 and subsidiary weight 8a are displaced by the acceleration that was given from the outside. Thus, the distortions which occur in four arm portions 9a to 9d are detected by sensing portions RX1 to RX4, RY1 to RY4, and RZ1 to RZ4. Therefore, acceleration sensor 6 can detect acceleration in three axis directions.

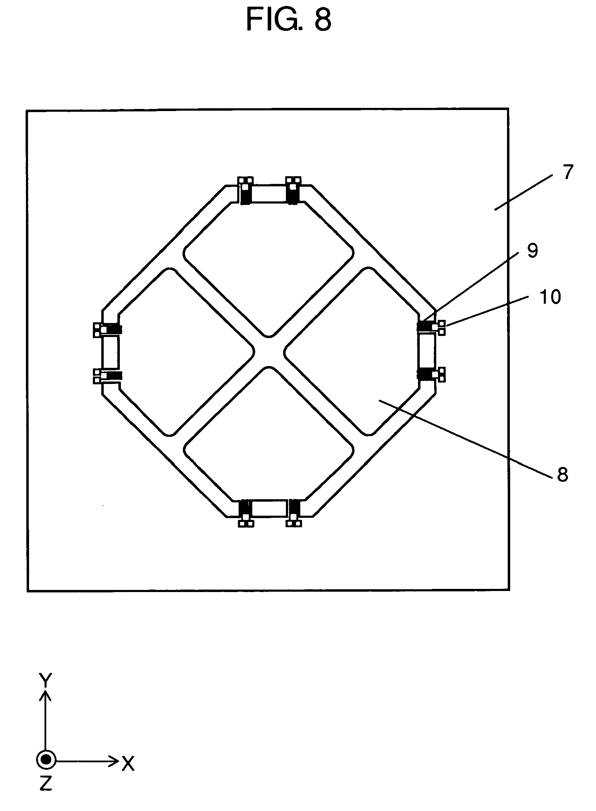

This invention is not limited to the acceleration sensor of a so-called double cantilever beam structure that weight portion 8 is supported by a plurality of arm portions 9. The effect of the present invention can also be obtained in an acceleration sensor of a so-called single cantilever beam structure that one side of weight portion 8 which is formed in a hollow provided in frame 7 is supported by arm portion 9 as shown Fig. 8.

### INDUSTRIAL APPLICABILITY

The acceleration sensor of the present invention has a small resistance temperature coefficient and a large gauge factor, so that it can be used in a wide temperature range and be useful in a mobile terminal or a vehicle because of its high sensitive.

### REFERENCE MARKS IN THE DRAWINGS

| | |
|---|---|
| 1 | Acceleration sensor |
| 2 | Frame |
| 3 | Weight portion |
| 4 | Arm portion |
| 5 | Sensing portion |
| 6 | Acceleration sensor |
| 7 | Frame |
| 8 | Weight portion |
| 8a | Subsidiary weight |
| 9, 9a, 9b, 9c, 9d | Arm portion |
| 10, 14 | Sensing portion |
| 11, 15 | First electrode portion |
| 12, 16 | Second electrode portion |
| 13, 17 | Strain resistor portion |
| 13a | First end |
| 13b | Second end |
| 13c | Portion |
| 13d | First meander portion |
| 13e | Connection portion |
| 13f | Second meander portion |
| 18 | Center line |
| 19, 20, 21 | Voltage detecting portion |
| RX1, RX2, RX3, RX4 | Sensing portion |
| RY1, RY2, RY3, RY4 | Sensing portion |
| RZ1, RZ2, RZ3, RZ4 | Sensing portion |

## Claims

1. An acceleration sensor (6) comprising:
a frame (7);
a weight portion (8);
an arm portion (9) for connecting the frame and the weight portion; and
a sensing portion (10) for detecting a bend of the arm portion,
wherein the sensing portion includes a first electrode portion (11) a second electrode portion (12) and a strain resistor portion (13)
the first electrode portion and the second electrode portion are provided on the weight portion,
a first end (13a) of the strain resistor portion is connected to the first electrode portion, and a second end (13b) of the strain resistor portion is connected to the second electrode portion,
the strain resistor portion is formed of a strain resistor film comprising a metal oxide, and
the strain resistor portion is formed in meander shape in a part which is nearer to the weight portion than the frame in the arm portion.

2. The acceleration sensor according to claim 1, wherein a portion, which is a part of meander-shaped part of the strain resistor portion is formed on the weight portion.

3. An acceleration sensor (6) comprising:
a frame (7);
a weight portion (8),
an arm portion (9) for connecting the frame and the weight portion; and
a sensing portion (10) for detecting a bend of the arm portion,
wherein the sensing portion includes a first electrode portion (11), a second electrode portion (12) and a strain resistor portion (13)
the first electrode portion and the second electrode portion are provided on the weight portion,
a first end (13a) of the strain resistor portion is connected to the first electrode portion, and a second end (13b) of the strain resistor portion is connected to the second electrode portion,
the strain resistor portion is formed of a strain resistor film comprising a metal oxide, and
the strain resistor portion is formed in meander shape in a part which is nearer to the frame than the weight portion in the arm portion.

4. The acceleration sensor according to claim 3, wherein a portion, which is a part of meander-shaped part of the strain resistor portion is formed on the frame.

5. The acceleration sensor according to claim 1 or claim 3, wherein a part formed in meander shape in the strain resistor portion includes a first meander portion (13d) a second meander portion (13f) and a connection portion (13e),
the first meander portion and the second meander portion are bent alternately, and
the connection portion connects the first meander portion and the second meander portion.

6. The acceleration sensor according to claim 1 or claim 3, further comprising a second sensing portion (14), wherein the sensing portion and the second sensing portion are formed line symmetrically to a center line (18) of the arm portion.

## Patentansprüche

1. Beschleunigungssensor (6), umfassend:
einen Rahmen (7);
einen Gewichtsabschnitt (8);
einen Armabschnitt (9) zum Verbinden des Rahmens und des Gewichtsabschnitts; und
einen Abfühlabschnitt (10) zum Erkennen einer Biegung des Armabschnitts,
wobei der Abfühlabschnitt einen ersten Elektrodenabschnitt (11), einen zweiten Elektrodenabschnitt (12) und einen Beanspruchungswiderstandsabschnitt (13) enthält,
wobei der erste Elektrodenabschnitt und der zweite Elektrodenabschnitt auf dem Gewichtsabschnitt vorgesehen sind,
wobei ein erstes Ende (13a) des Beanspruchungswiderstandsabschnitts mit dem ersten Elektrodenabschnitt verbunden ist und ein zweites Ende (13b) des Beanspruchungswiderstandsabschnitts mit dem zweiten Elektrodenabschnitt verbunden ist,
wobei der Beanspruchungswiderstandsabschnitt aus einer Beanspruchungswiderstandsfolie ausgebildet ist, die ein Metalloxid umfasst, und
wobei der Beanspruchungswiderstandsabschnitt in Mäanderform in einem Teil ausgebildet ist, das dem Gewichtsabschnitt näher als dem Rahmen im Armabschnitt ist.

2. Beschleunigungssensor nach Anspruch 1, wobei ein Abschnitt, der ein Teil des mäanderförmigen Teils des Beanspruchungswiderstandsabschnitts ist, auf dem Gewichtsabschnitt ausgebildet ist.

3. Beschleunigungssensor (6), umfassend:
einen Rahmen (7);
einen Gewichtsabschnitt (8);
einen Armabschnitt (9) zum Verbinden des Rahmens und des Gewichtsabschnitts; und
einen Abfühlabschnitt (10) zum Erkennen einer Biegung des Armabschnitts,
wobei der Abfühlabschnitt einen ersten Elektrodenabschnitt (11), einen zweiten Elektrodenabschnitt (12) und einen Beanspruchungswiderstandsabschnitt (13) enthält,
wobei der erste Elektrodenabschnitt und der zweite Elektrodenabschnitt auf dem Gewichtsabschnitt vorgesehen sind,
wobei ein erstes Ende (13a) des Beanspruchungswiderstandsabschnitts mit dem ersten Elektrodenabschnitt verbunden ist und ein zweites Ende (13b) des Beanspruchungswiderstandsabschnitts mit dem zweiten Elektrodenabschnitt verbunden ist,
wobei der Beanspruchungswiderstandsabschnitt aus einer Beanspruchungswiderstandsfolie ausgebildet ist, die ein Metalloxid umfasst, und
wobei der Beanspruchungswiderstandsabschnitt in Mäanderform in einem Teil ausgebildet ist, das dem Rahmen näher als dem Gewichtsabschnitt im Armabschnitt ist.

4. Beschleunigungssensor nach Anspruch 3, wobei ein Abschnitt, der ein Teil des mäanderförmigen Teils des Beanspruchungswiderstandsabschnitts ist, auf dem Rahmen ausgebildet ist.

5. Beschleunigungssensor nach einem der Ansprüche 1 oder 3, wobei ein Teil, das in Mäanderform im Beanspruchungswiderstandsabschnitt ausgebildet ist, einen ersten Mäanderabschnitt (13d), einen zweiten Mäanderabschnitt (13f) und einen Verbindungsabschnitt (13e) enthält,
wobei der erste Mäanderabschnitt und der zweite Mäanderabschnitt abwechselnd gebogen sind, und
wobei der Verbindungsabschnitt den ersten Mäanderabschnitt und den zweiten Mäanderabschnitt miteinander verbindet.

6. Beschleunigungssensor nach einem der Ansprüche 1 oder 3, ferner umfassend einen zweiten Abfühlabschnitt (14), wobei der Abfühlabschnitt und der zweite Abfühlabschnitt liniensymmetrisch zu einer Mittellinie (18) des Armabschnitts ausgebildet sind.

## Revendications

1. Capteur d'accélération (6) comprenant :
un cadre (7) ;
une partie de poids (8) ;
une partie de bras (9) destinée à relier le cadre et la partie de poids ; et
une partie de détection (10) destinée à détecter une courbure de la partie de bras,
où la partie de détection comporte une première partie d'électrode (11), une deuxième partie d'électrode (12) et une partie de résistance à la déformation (13),
la première partie d'électrode et la deuxième partie d'électrode sont prévues sur la partie de poids,
une première extrémité (13a) de la partie de résistance à la déformation est reliée à la première partie d'électrode, et une deuxième extrémité (13b) de la partie de résistance à la déformation est reliée à la deuxième partie d'électrode,
la partie de résistance à la déformation est formée d'un film de résistance à la déformation comprenant un oxyde métallique, et
la partie de résistance à la déformation est formée sous forme de méandre dans une portion qui est plus proche de la partie de poids que le cadre dans la partie de bras.

2. Capteur d'accélération selon la revendication 1, dans lequel une partie, qui est une portion d'une portion en forme de méandre de la partie de résistance à la déformation, est formée sur la partie de poids.

3. Capteur d'accélération (6) comprenant :
un cadre (7) ;
une partie de poids (8) ;
une partie de bras (9) destinée à relier le cadre et la partie de poids ; et
une partie de détection (10) destinée à détecter une courbure de la partie de bras,
où la partie de détection comporte une première partie d'électrode (11), une deuxième partie d'électrode (12) et une partie de résistance à la déformation (13),
la première partie d'électrode et la deuxième partie d'électrode sont prévues sur la partie de poids,
une première extrémité (13a) de la partie de résistance à la déformation est reliée à la première partie d'électrode, et une deuxième extrémité (13b) de la partie de résistance à la déformation est reliée à la deuxième partie d'électrode,
la partie de résistance à la déformation est formée d'un film de résistance à la déformation comprenant un oxyde métallique, et
la partie de résistance à la déformation est formée sous forme de méandre dans une portion qui est plus proche du cadre que la partie de poids dans la partie de bras.

4. Capteur d'accélération selon la revendication 3, dans lequel une partie, qui est une portion d'une portion en forme de méandre de la partie de résistance à la déformation, est formée sur le cadre.

5. Capteur d'accélération selon la revendication 1 ou 3, dans lequel une portion formée sous forme de méandre dans la partie de résistance à la déformation comporte une première partie en méandre (13d), une deuxième partie en méandre (13f) et une partie de liaison (13e),
la première partie en méandre et la deuxième partie en méandre sont alternativement courbées, et
la partie de liaison relie la première partie en méandre et la deuxième partie en méandre.

6. Capteur d'accélération selon la revendication 1 ou 3, comprenant en outre une deuxième partie de détection (14), où la partie de détection et la deuxième partie de détection sont formées symétriquement en ligne par rapport à une ligne centrale (18) de la partie de bras.
